# EUROPEAN PATENT SPECIFICATION

(11) **EP 2 073 382 B1**
(45) Date of publication and mention of the grant of the patent: **27.04.2011**
(21) Application number: 07123593.1
(22) Date of filing: 19.12.2007
(51) Int. Cl.: H03F 3/217, H03F 3/26

(54) **A method for signal amplification, a current switched power amplifier system, a base station, a mobile station and a communication network therefor**
Verfahren zur Signalverstärkung, stromgeschaltetes Verstärkersystem, Basisstation, Mobilstation und Kommunikationsnetzwerk dafür
Procédé pour l'amplification de signaux, système amplificateur d'alimentation commuté, station de base, station mobile et réseau de communication correspondant

(43) Date of publication of application: 24.06.2009
(73) Proprietor: Alcatel Lucent, 75008 Paris (FR)
(72) Inventor: Fischer, Georg, 90425 Nürnberg (DE)
(74) Representative: Brose, Gerhard

(56) References cited:
- US-A- 3 611 001
- US-A1- 2003 048 138
- HIDENORI KOBAYASHI ET AL: "Current-Mode Class-D Power Amplifiers for High-Efficiency RF Applications" IEEE TRANSACTIONS ON MICROWAVE THEORY AND TECHNIQUES, IEEE SERVICE CENTER, PISCATAWAY, NJ, US, vol. 49, no. 12, 1 December 2001 (2001-12-01), XP011038519 ISSN: 0018-9480
- HOSSEIN MASHAD NEMATI ET AL: "High Efficiency LDMOS Current Mode Class-D Power amplifier at 1 GHz" MICROWAVE CONFERENCE, 2006. 36TH EUROPEAN, IEEE, PI, 1 September 2006 (2006-09-01), pages 176-179, XP031005527 ISBN: 978-2-9600551-6-0
- ASBECK P M ET AL: "Design of High-Efficiency Current-Mode Class-D Amplifiers for Wireless Handsets" IEEE TRANSACTIONS ON MICROWAVE THEORY AND TECHNIQUES, IEEE SERVICE CENTER, PISCATAWAY, NJ, US, vol. 53, no. 1, 1 January 2005 (2005-01-01), pages 144-151, XP011125360 ISSN: 0018-9480
- JI-YEON KIM ET AL: "A 50 W LDMOS current mode 1800 MHz class-D power amplifier" MICROWAVE SYMPOSIUM DIGEST, 2005 IEEE MTT-S INTERNATIONAL LONG BEACH, CA, USA 12-17 JUNE 2005, PISCATAWAY, NJ, USA,IEEE, 12 June 2005 (2005-06-12), pages 1295-1298, XP010844865 ISBN: 978-0-7803-8846-8
- LONG A ET AL: "A 13W current mode class D high efficiency 1 GHz power amplifier" THE 2002 45TH. MIDWEST SYMPOSIUM ON CIRCUITS AND SYSTEMS. CONFERENCE PROCEEDINGS. TULSA, OK, AUG. 4 - 7, 2002; [MIDWEST SYMPOSIUM ON CIRCUITS AND SYSTEMS], NEW YORK, NY : IEEE, US, vol. 1, 4 August 2002 (2002-08-04), pages 33-36, XP010635142 ISBN: 978-0-7803-7523-9

## Description

The invention relates to a method for signal amplification according to the preamble of claim 1, a current switched power amplifier system according to the preamble of claim 3, a base station, a mobile station, and a communication network.

Mobile communication systems like e.g. Universal Mobile Telecommunications System (UMTS), Third Generation Partnership Project Long Term Evolution (3GPP LTE) or Worldwide Interoperability for Microwave Access (WIMAX) require power amplifiers with high output power at frequencies up to 3.8 GHz.

In the communication industry, there is always a pressure to reduce costs, especially Operational Expenditures (OPEX) and equipment costs (Capital Expenditures CAPEX), to be competitive. Therefore the industry is permanently searching for possibilities to reduce the cost for operation, of equipment and of the goods sold. One means to reduce the costs for operation is to increase the power efficiency of the analogue hardware by changing the RF power amplifier architecture.

As an alternative to the currently used linear operation mode of e.g. A/AB or C class amplifiers, a new architecture may use so-called switched mode amplifiers, as e.g. class-S amplifiers, to improve the power efficiency. This new approach inherently leads to higher efficiency of the power amplifier of theoretically 100% and by means of the digital approach reduces analogue imperfections and liability to errors.

Switched mode amplifiers, as e.g. class S amplifiers, are a preferred architecture, as digital power amplifiers fit the general direction of the architecture for software defined radio (SDR) and thus higher level of digitization of the transceiver, and as the switched mode amplifier architecture is the only architecture offering a 100% theoretical efficiency limit. A Class-AB amplifier architecture for instance can never have an efficiency better than 78% due to fundamental physical limitations. It is above all in the operator's interest to get as close as possible to the theoretical efficiency limit.

In said switched mode radio frequency (RF) power amplifiers, the transistor is not amplifying the input signal linearly, but is acting as a switch in the ideal case. As an ideal switch does not dissipate power, a theoretical power efficiency of 100% could be reachable.

Witch a switched mode power amplifier architecture relying on a current switched circuit topology, the switching transistors are part time operated with reverse bias between drain and source. This means that the transistor is operated in the third quadrant of the output current versus output voltage diagram, i.e. with a negative drain-source voltage More generally speaking when using e.g. a bipolar or a field-effect transistor (FET), the loadline of the transistor is no longer limited to the first quadrant of the current versus voltage diagram. With a class-AB, C, D, E, F power amplifier architecture this never happens, i.e. the problem is specific for the switched mode power amplifier architecture. The problem is now that operation with reverse bias between drain and source, i.e. negative drain-source voltage and at the same time negative drain current of the transistor, is associated with losses hurting efficiency. Simulations have revealed an increase of efficiency by around 10% when avoiding operation with reverse bias between drain and source :

Without such operation with reverse bias between drain and source, energy consumption is reduced leading to less OPEX for operators. Furthermore less effort for cooling the power amplifiers is required allowing for more dense packaging of power amplifiers. This results in a smaller form factor of the base station, which in turn results in less real estate needed. This means a further secondary reduction of OPEX.

Furthermore, operation with reverse bias between drain and source may also be a risk in terms of reliability for the transistor, as the voltage potential of the gate is no longer lower than that of the drain.

In the Master of Science Thesis from Anthony Lawrence Long, Department of Electrical and Computer Engineering, University of California, Santa Barbara, CA 93106-9560 from May 2003, the basic principle of current switched mode class D power amplifier architecture is disclosed.

Other current switched amplifiers are known from US 3 611 001 and US 2003/048138, and from the IEEE papers
- KOBAYASHI ET AL: "Current-Mode Class-D Power Amplifiers for High-Efficiency RF Applications" IEEE TRANSACTIONS ON MICROWAVE THEORY AND TECHNIQUES, IEEE SERVICE CENTER, PISCATAWAY, NJ, US, vol. 49, no. 12, 1 December 2001 (2001-12-01), XP011038519 ISSN: 0018-9480
- HOSSEIN MASHAD NEMATI ET AL: "High Efficiency LDMOS Current Mode Class-D Power amplifier at 1 GHz" MICROWAVE CONFERENCE, 2006. 36TH EUROPEAN, IEEE, PI, 1 September 2006 (2006-09-01), pages 176-179, XP031005527 ISBN: 978-2-9600551-6-0
- ASBECK P M ET AL: "Design of High-Efficiency Current-Mode Class-D Amplifiers for Wireless Handsets" IEEE TRANSACTIONS ON MICROWAVE THEORY AND TECHNIQUES, IEEE SERVICE CENTER, PISCATAWAY, NJ, US, vol. 53, no. 1, 1 January 2005 (2005-01-01), pages 144-151, XP011125360 ISSN: 0018-9480
- JI-YEON KIM ET AL: "A 50 W LDMOS current mode 1800 MHz class-D power amplifier" MICROWAVE SYMPOSIUM DIGEST, 2005 IEEE MTT-S INTERNATIONAL LONG BEACH, CA, USA 12-17 JUNE 2005, PISCATAWAY, NJ, USA,IEEE, 12 June 2005 (2005-06-12), pages 1295-1298, XP010844865 ISBN: 978-0-7803-8846-8
- LONG A ET AL: "A 13 W current mode class D high efficiency 1 GHz power amplifier" THE 2002 45TH. MIDWEST SYMPOSIUM ON CIRCUITS AND SYSTEMS. CONFERENCE PROCEEDINGS. TULSA, OK, AUG. 4 - 7, 2002; [MIDWEST SYMPOSIUM ON CIRCUITS AND SYSTEMS], NEW YORK, NY : IEEE, US, vol. 1, 4 August 2002 (2002-08-04), pages 33-36, XP010635142 ISBN: 978-0-7803-7523-9.

The object of the invention is thus to propose a method to avoid operation of switching transistors of a switched mode power amplifier architecture relying on a current switched circuit topology with reverse bias between drain and source. This object is achieved by a method for signal amplification according to the teaching of claim 1, and a current switched power amplifier system, according to the teaching of claim 3.

The main idea of the invention is to put diodes in series with the transistors of the current switched circuit topology. This shields the transistors from reverse bias between drain and source and thus a steering of the loadline into the third quadrant of a drain-source current versus drain-source voltage diagram its avoided.

Further developments of the invention can be gathered from the dependent claims and the following description,

In the following the invention will be explained further masking reference to the attached drawings.
Fig. 1 schematically shows a switched mode power amplifier architecture relying on a current switched circuit topology according to the state-of-the-art.
Fig. 2 schematically shows a switched mode power amplifier architecture replying on a current switched circuit topology with diodes in series according to the invention.
Fig. 3 shows on the left side the leadlines in a output current versus output voltage diagram of a transistor in a switched mode power amplifier architecture relying on a current switched circuit topology according to the state-of-the-art, and on the right side the corresponding diagram of a transistor in a switched mode power amplifier architecture replying on a current switched circuit topology with a diode in series according to the invention.

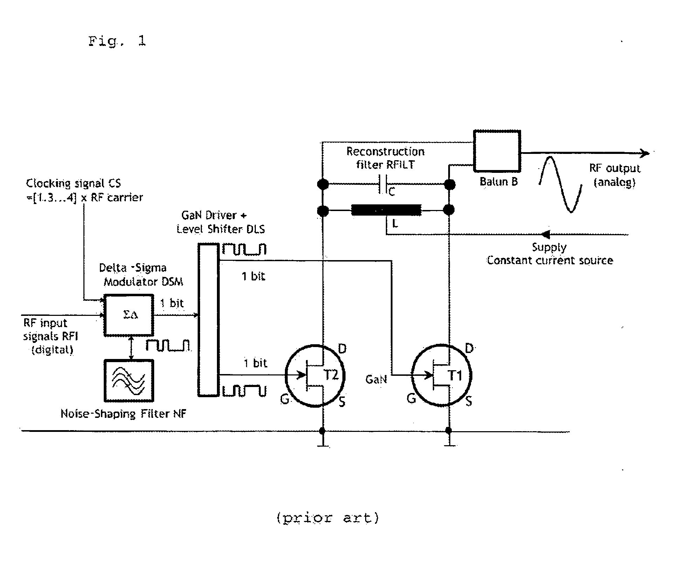

A current switched, power amplifier system according to the state-of-the-art as shown in fig. 1 comprises a delta-sigma modulator DSM with inputs for reception of a digital or analogue RF input signal RFI and for reception of a clocking signal CS. An output of the delta-sigma modulator DSM is connected to an input of a driver and level shifter DLS.

Preferably, the delta-sigma modulator DSM is connected to a noise-shaping filter NF.

A first output of the driver and level shifter DLS is connected to the gate of a first transistor T1, and a second output of the driver and level shifter DLS is connected to the gate of a second transistor T2.

Both the source of the first transistor T1 and the source of the second transistors T2 are connected to ground.

The drain of the first transistor T1 is connected to a first input of an inductor L and to a first input of a capacitor C, and the drain of the second transistor T2 is connected to a second input of the inductor L and to a second input of the capacitor C. The capacitor C and the inductor L build together a reconstruction filter RFILT. There are variants of the L-C filter topology which however are of no importance for the invention as disclosed.

The supply of a constant current source is connected to a third input of the inductor L.

Furthermore, the drain of the first transistor T1 is connected to a first input of a balun B, and the drain of the second transistor T2 is connected to a second input of the balun B. The balun B transforms a balanced input signal to a single ended signal. At the balun's output the analogue RF output signal is provided.

Preferably, the driver and level shifter DLS or the transistors T1 and T2 are fabricated in Gallium Nitride (GaN) technology.

In a method for signal amplification using a current switched power amplifier system according to the state-of-the-art as shown in fig. 1, digital or analogue RF input signals are sent to the delta-sigma modulator DSM. Furthermore, clocking signals with a multiple of the RF carrier frequency are sent to the delta-sigma modulator DSM.

In the delta-sigma modulator DSM, the digital or analogue RF input signals are converted into digital 1-bit or higher resolution signals using a so-called sample-and-hold output. The sampling rate is determined by the received clocking signals. The digital 1-bit or multibit signals are provided at the output of the delta-sigma modulator DSM.

Preferably, the noise shaping filter NF is used to minimize quantization error by means of shifting quantisation noise into frequency ranges that are less or not relevant for signal processing.

Said digital 1-bit signals are sent to the driver and level shifter DLS that generates first driver signals based on the digital 1-bis signals and second driver signals based on the inverted digital 1-bit signals. The first driver signals are sent to the gate of the first transistor T1, and the second driver signals are sent to the gate of the second transistor T2. The output signals of the driver and level shifter DLS are thus in antiphase which means if the first transistor T1 is on, the second transistor T2 is off and vice versa. The described amplifier architecture with two transistor T1, T2 is just an example, and in alternative architectures, more than two transistors are used, which has however no influence on the invention. Such alternative architectures are e.g. multibit architectures, using two transistors more per each bit more.

In the first transistor T1 and in the second transistor T2, the first driver signals and the second driver signals respectively are amplified resulting in first and a second amplifier signals.

The capacitor C and the inductor L together build a reconstruction filter RFILT used to generate smooth analogue signals out of the first and the second amplifier signals.

The smoothed first and second analogue signals are sent to the balun B, in which the smoothed first and second analogue signals are added together, thus removing any noise that has been picked up along the way. In other words, the balun B converts balanced signals to unbalanced signals. The unbalanced RF output signals are provided at the output of the balun B.

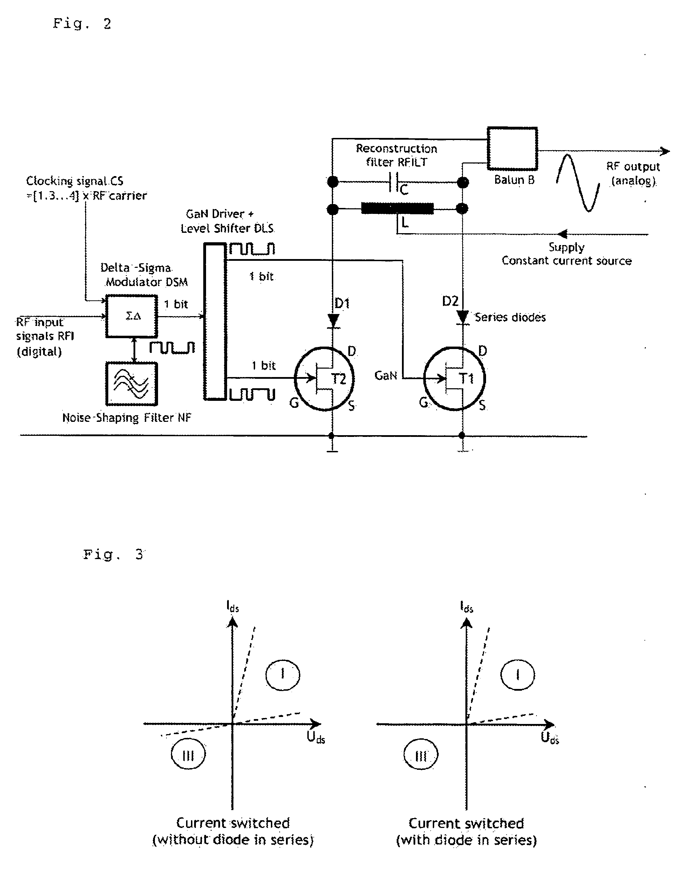

The left diagram in fig. 3 schematically shows the leadlines in a drain-source current I_{DS} versus drain-source voltage U_{DS} diagram of a transistor in a switched mode power amplifier architecture relying on a current switched circuit topology according to the state-of-the-art. Ideally, the drain-source current I_{DS} through the transistors T1, T2 in fig. 1 is rectangular, and the drain-source voltage U_{DS} is sinusoidal.

It can be seen, that the transistor is part time operated in the third quadrant of the drain-source current I_{DS} versus drain-source voltage U_{DS} diagram. This means the transistor is operated with a negative drain-source voltage. As already mentioned before, the problem of such an operation with reverse bias between drain and source, i.e. negative drain-source voltage and at the same time negative drain-source current, is associated witch losses hurting efficiency. Furthermore, operation with reverse bias between drain and source may also be a risk in terms of reliability for the transistor, as e.g. in case of a FET transistor, the voltage potential of the gate no longer is lower than that of the drain.

According to the invention, in order to avoid operation of the transistors T1, T2 with reverse bias between drain and source, it is proposed to put diodes in series with the transistors T1, T2 of the current switched circuit topology as depicted in fig. 1. In case of e.g. FET transistors, these are shielded from negative drain-source voltage U_{DS} and thus a steering of the loadline into the third quadrant of the drain-source current I_{DS} versus drain-source voltage U_{DS} diagram is avoided.

A respective current switched power amplifier system according to the invention is shown in fig. 2.

Said current switched power amplifier system according to the invention is basically identical in construction to the current switched power amplifier system according to the state-of-the-art as shown in fig. 1 with the difference that a diode D1, D2 is connected in series with the drain D of transistor T1 and transistor T2 respectively.

In the example depicted in fig. 2, it is assumed that the transistor T1 and transistor T2 are both Field Effect transistors (FET). However, the invention is not restricted to a specific class of transistors like FETs. It can be applied in an analogue way also for Bipolar npn or pnp, MISHFET or MISFET transistors and various other classes of transistors or tubes.

The n-doped part of the diode D1, D2 is connected to the drain D of transistor T1 and transistor T2 respectively, and the p-doped part of the diode D1, D2 is connected to the balun B.

If the diode is reverse biased, i.e. if the voltage potential is lower on the side of the diode that is connected to the balun B than on the side that is connected to the drain D of transistor T1 and transistor T2 respectively, operation of transistor T1 and transistor T2 respectively with negative drain-source voltage is avoided.

If pnp-transistors are used instead of npn-transistors, the n-doped part of the diode D1, D2 is connected to the balun B, and the p-doped part of the diode D1, D2 is connected to the drain D of transistors T1 and transistors T2 respectively.

The right diagram in fig. 3 schematically shows the idealized loadlines in a drain-source current I_{DS} versus drain-source voltage U_{DS} diagram of a FETtransiStor T1, T2 in a switched mode power amplifier architecture relying on a current switched circuit topology with a diode D1, D2 in series according to the invention.

It can be seen that the transistor T1, T2 is not operated in the third quadrant of the drain-source current T_{DS} versus drain-source voltage U_{DS} diagram which increases the efficiency of the transistor T1, T2 as already mentioned above.

Such a current switched power amplifier system according to the invention as describes above can be comprised in a transmitter used for transmission in a base station or a mobile station that are part of a communication network.

## Claims

1. A method for signal amplification using a current switched power amplifier system comprising at least two transistors (T1, T2), **characterized in, that**
• a digital signal is sent from a delta-sigma modulator (DSM) to a level shifter (DLS) ,
• the digital signal is sent from the level shifter (DLS) to the gate (G) of the first of said at least two transistors (T1) and the digital signal is inverted and sent from the level shifter (DLS) to the gate (G) of the second of said at least two transistors (T2),
• and at least one of said at least two transistors (T1, T2) is shielded from reverse bias between drain (D) and source (S) by means of at least one diode (D1, D2) that is in series with said at least one of said at least two transistors (T1, T2).

2. A method according to claim 1, **characterized in, that**
• the digital signals are sent from the drains (D) of said at least two transistors (T1, T2) through a reconstruction filter (RFILT) resulting in smooth analogue signals,
• and said analogue signals are combined in a balun (B), resulting in an unbalanced analogue output signal.

3. A current switched power amplifier system comprising at least two transistors (T1, T2), **characterized in, that**
• a delta-sigma modulator (DSM) is connected to a level shifter (DLS), said delta-sigma modulator (DSM) being adapted to send a digital signal to the level shifter (DLS),
• the level shifter (DLS) is connected to the gates (G) of said at least two transistors (T1, T2), said level shifter (DLS) being adapted to send the digital signal to the gate (G) of the first of said at least two transistors (T1), and to invert and send the digital signal to the gate (G) of the second of said at least two transistors (T2),
• and at least one diode (D1, D2) is in series with at least one of said at least two transistors (T1, T2) shielding said at least one of said at least two transistors (T1, T2) from an operation with reverse bias between drain (D) and source (S).

4. A base station comprising at least one current switched power amplifier system according to claim 3.

5. A mobile station comprising at least one current switched power amplifier system according to claim 3.

6. A communication network with at least one base station according to claim 4, or at least one mobile station according to claim 5.

## Patentansprüche

1. Ein Verfahren zur Signalverstärkung unter Verwendung eines stromgeschalteten Leistungsverstärkersystems mit mindestens zwei Transistoren (T1, T2), **dadurch gekennzeichnet, dass**
• ein digitales Signal von einem Delta-Sigma-Modulator (DSM) an einen Level-Shifter (DLS) gesendet wird,
• das digitale Signal von dem Level-Shifter (DLS) an das Gate (G) des ersten der besagten mindestens zwei Transistoren (T1) gesendet wird und das digitale Signal invertiert und von dem Level-Shifter (DLS) an das Gate (G) des zweiten der besagten mindestens zwei Transistoren (T2) gesendet wird,
• und mindestens einer der besagten mindestens zwei Transistoren (T1, T2) durch mindestens eine Diode (D1, D2), welche mit dem besagten mindestens einen der besagten mindestens zwei Transistoren (T1, T2) in Reihe liegt, von der Sperrvorspannung zwischen dem Drain (D) und der Source (S) abgeschirmt wird.

2. Ein Verfahren nach Anspruch 1, **dadurch gekennzeichnet, dass**
• die digitalen Signale von den Drains (D) der besagten mindestens zwei Transistoren (T1, T2) über einen Rekonstruktionsfilter (RFILT) gesendet werden, wodurch ein geglättetes analoges Signal entsteht,
• und die besagten analogen Signale in einem Balun kombiniert werden (B), wodurch ein unsymmetrisches analoges Ausgangssignal entsteht.

3. Ein stromgeschaltetes Leistungsverstärkersystem mit mindestens zwei Transistoren (T1, T2), **dadurch gekennzeichnet, dass**
• ein Delta-Sigma-Modulator (DSM) an einen Level-Shifter (DLS) angeschlossen wird, wobei der besagte Delta-Sigma-Modulator (DSM) dazu ausgelegt ist, ein digitales Signal an den Level-Shifter (DLS) zu senden,
• der Level-Shifter (DLS) an die Gates (G) der besagten mindestens zwei Transistoren (T1, T2) angeschlossen ist, wobei der besagte Level-Shifter (DLS) dazu ausgelegt ist, das digitale Signal an das Gate (G) des ersten der besagten mindestens zwei Transistoren (T1) zu senden und das digitale Signal zu invertieren und an das Gate (G) des zweiten der besagten mindestens zwei Transistoren (T2) zu senden,
• und mindestens eine Diode (D1, D2) mit mindestens einem der besagten mindestens zwei Transistoren (T1, T2), in Reihe liegt, wodurch der besagte mindestens eine der besagten mindestens zwei Transistoren (T1 T2) von einem Betrieb mit Sperrvorspannung zwischen dem Drain (D) und der Source (S) abgeschirmt wird.

4. Eine Basisstation mit mindestens einem stromgeschalteten Leistungsverstärkersystem nach Anspruch 3.

5. Eine Mobilstation mit mindestens einem stromgeschalteten Leistungsverstärkersystem nach Anspruch 3.

6. Ein Kommunikationsnetzwerk mit mindestens einer Basisstation nach Anspruch 4, oder mindestens einer Mobilstation nach Anspruch 5.

## Revendications

1. Procédé d'amplification du signal en utilisant un système amplificateur de puissance à commutation de courant comprenant au moins deux transistors (T1, T2), **caractérisé en ce que**
• un signal numérique est envoyé depuis un modulateur delta-sigma (DSM) vers un translateur de niveau (DLS),
• le signal numérique est envoyé du translateur de niveau (DLS) vers la gâchette (G) du premier desdits au moins deux transistors (T1) et le signal numérique est inversé et envoyé du translateur de niveau (DLS) vers la gâchette (G) du deuxième desdits au moins deux transistors (T2),
• et au moins l'un desdits au moins deux transistors (T1, T2) est protégé contre la polarisation inverse entre le drain (D) et la source (S) au moyen d'au moins une diode (D1, D2) qui est branchée en série avec au moins l'un desdits au moins deux transistors (T1, T2).

2. Procédé selon la revendication 1, **caractérisé en ce que**
• les signaux numériques sont envoyés depuis les drains (D) desdits au moins deux transistors (T1, T2) à travers un filtre de reconstruction (RFILT) afin de produire des signaux analogiques réguliers,
• et lesdits signaux analogiques sont combinés en un transformateur symétriseur (B), ce qui produit un signal de sortie analogique asymétrique.

3. Système amplificateur de puissance à commutation de courant comprenant au moins deux transistors (T1, T2), **caractérisé en ce que**
• un modulateur delta-sigma (DSM) est connecté à un translateur de niveau (DLS), ledit modulateur delta-sigma (DSM) étant conçu pour envoyer un signal numérique au translateur de niveau (DLS),
• le translateur de niveau (DLS) est connecté aux gâchettes (G) desdits au moins deux transistors (T1, T2), ledit translateur de niveau (DLS) étant conçu pour envoyer le signal numérique à la gâchette (G) du premier desdits au moins deux transistors (T1) et pour inverser et envoyer le signal numérique à la gâchette (G) du deuxième desdits au moins deux transistors (T2),
• et au moins une diode (D1, D2) est branchée en série avec au moins l'un desdits au moins deux transistors (T1, T2) pour protéger ledit au moins un desdits au moins deux transistors (T1, T2) contre un fonctionnement avec une polarisation inverse entre le drain (D) et la source (S).

4. Station de base comprenant au moins un système amplificateur de puissance à commutation de courant selon la revendication 3.

5. Station mobile comprenant au moins un système amplificateur de puissance à commutation de courant selon la revendication 3.

6. Réseau de communication comprenant au moins une station de base selon la revendication 4 ou au moins une station mobile selon la revendication 5.
